# EUROPEAN PATENT APPLICATION

(11) **EP 1 063 691 A2**
(43) Date of publication of application: **27.12.2000**
(21) Application number: 00301655.7
(22) Date of filing: 01.03.2000
(51) Int. Cl.: H01L 21/311, H01J 37/32

(54) **A dry-etching method and an equipment for dry-etching**

(30) Priority: 21.06.1999 JP 17367899
(71) Applicant: Tohoku University, Sendai City, Miyagi Prefecture (JP)
(72) Inventor: Matsuura, Takashi, Sendai City, Miyagi Pref. (JP); Murota, Junichi, Sendai City, Miyagi Pref. (JP)
(74) Representative: Mohun, Stephen John

(57) **Abstract**

An argon gas is introduced into an ECR plasma-generating chamber from a gas flow rate-controlling equipment with a gas supplying tube, and a hydrogen gas is introduced into a vacuum chamber with a gas supplying tube as well. Then, an ECR plasma is generated in the ECR plasma-generating chamber and is introduced into the vacuum chamber. The ECR plasma is irradiated to a silicon nitride film and thereby only nitrogen elements are removed. Changing the flow rates of the hydrogen gas and the argon gas, an ECR plasma generated as above-mentioned is irradiated to the silicon nitride film and thereby only silicon elements are removed.

## Description

This invention relates a dry-etching method and an equipment for dry-etching, and more particularly a dry-etching method and an equipment for dry-etching preferably usable for dry-etching a solid material composed of

plural kinds of constituting element having strong binding forces. In the past, when a solid material such as a semiconductor material or an insulating material is dry-etched, the dry-etching is carried out by using the following equipment.

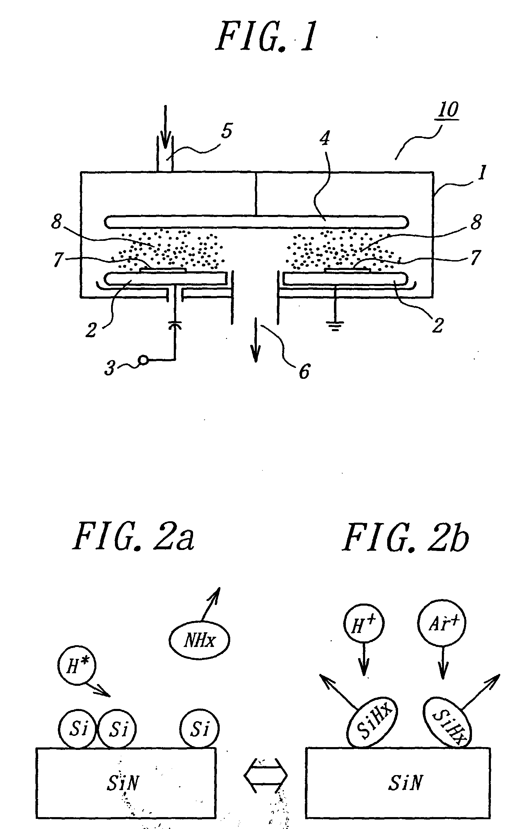

Fig. 1 shows a known dry-etching equipment.

A dry-etching equipment 10 has a chamber 1 and a RF electric power supply 3. Then, in the chamber 1, a susceptor 2 to hold a solid material 7, a plate 4, a gas inlet 5 and a gas outlet 6 are provided. The RF electric power source 3 is connected to the susceptor 2 and can generate an electric field having a given intensity with the plate 4 as an opposing electrode.

Then, after the interior of the chamber 1 is evacuated up to a given degree of vacuum with a vacuum pump (not shown), an etching gas is introduced therein from the gas inlet 5. The etching gas pressure in the chamber 1 is maintained in a given value by controlling a gas introducing amount from the gas inlet 5 and an evacuation rate (a gas evacuating amount) from the gas outlet 6, and thereafter an etching gas plasma 8 is generated in between the susceptor 2 and the plate 4 by applying a given voltage from the RF electric power supply 3 to the susceptor 2 on which the solid material 7 is set.

Just then, the surfaces of the solid material 7 are exposed to the etching gas plasma 8, and thereby, on the surfaces is formed etching induced substances. Then, the etching induced substances are removed by the bombardment of the ion particles in the etching gas plasma, and thereby the solid material 7 is dry-etched.

In such a dry-etching, from the view of effective etching-control of an atomic layer order or a molecular layer order, it is desired to remove the surfaces of the solid material by one atomic layer or by one molecular layer.

In a solid material such as silicon or gallium arsenide, the following two step-dry etching enables the surfaces of the solid material to be dry-etched by one atomic layer or by one molecular layer:
① the step for the etching gas particles to be absorbed to the surfaces of the solid material,
② the step for etching induced substances to be generated and to be removed by ion irradiation.

However, the above method has difficulty controlling the one atomic layer- or one molecular layer-dry etching in the case of dry-etching a solid material other than silicon or the like. Particularly, in the case that the solid material is composed of plural elements which strongly bind to one another the above method often has difficulty in dry-etching itself the solid material as well as the one molecular layer-dry etching or the like.

For example, when a solid material made of silicon nitride is so dry-etched that particles of chlorine gas as an etching gas are absorbed onto the surfaces of the solid material and the thus formed induced substances are removed, even if the conditions are optimized, the solid material is etched by only 0.1Å, about 1/19 molecular layer per one cycle in which the above steps ① and ② are carried out once.

Embodiments of the present invention aim to provide a dry-etching method and a dry-etching equipment usable for controlling one atomic layer order- or one molecular layer order-dry etching through the removing of the surfaces of the solid material composed of plural elements by one atomic layer or one molecular layer.

The present invention is defined in the attached independent claims, to which reference should now be made. Preferred features may be found in the sub-claims appended thereto.

A dry-etching method and a dry-etching equipment of the present invention are characterized, for attaining the above object, in that in dry-etching a solid material composed of plural kinds of constituting element, a different vapor treatment condition is employed for each kind of the constituting elements, and the solid material is dry-etched through the dependent removing of each kind of the constituting elements in vapor-treating the solid material.

The inventors have, in particular studied dry etching, through the controlling of one molecular layer dry etching, the solid material composed of the plural elements which itself has difficulty in being etched.

As a result, they have found that the optimized vapor treatment condition during the dry-etching is different for each kind of the plural constituting elements. Then, it has also been found that by selecting each optimized vapor treatment condition for each kind of the plural constituting elements and thereby removing each kind of the constituting elements independently, the dry-etching of the solid material as above-mentioned can be carried out and the one molecular layer-dry etching can be realized.

Figs. 2 show schematically an embodiment of the dry-etching process according to the present invention. Hereupon, Figs. 2 represent the dry-etching process in which a mixed gas of a hydrogen gas and an argon gas are employed for a solid material composed of silicon nitride.

First of all, the flow rate ratio of the hydrogen gas and the argon gas in the mixed gas and the electric power to supply with the mixed gas are set to values suitable for the vapor treatment condition for nitrogen elements constituting the solid material and then, a given plasma is generated. Just then, as shown in Fig. 2A, excited hydrogen particles are reacted only with the nitrogen elements to generate etching induced substances having a NHx composition on the surfaces of the solid material, later removed from the surfaces.

Thereafter, the flow rate ratio of the hydrogen gas and the argon gas in the mixed gas and the electric power to supply with the mixed gas are set to values suitable for the vapor treatment condition for silicon elements constituting the solid material. Just then, as shown in Fig. 2B, the excited hydrogen particles are reacted only with the silicon elements constituting the solid material to generate etching induced substances having a SiHx composition on the surfaces of the solid material, later removed from the solid material with the ion bombardment using argon ion particles.

Thus, by dry-etching the solid material exchanging alternately the vapor treatment conditions suitable for the nitrogen element-removal and the silicon element-removal, the one molecular layer-dry etching can be realized.

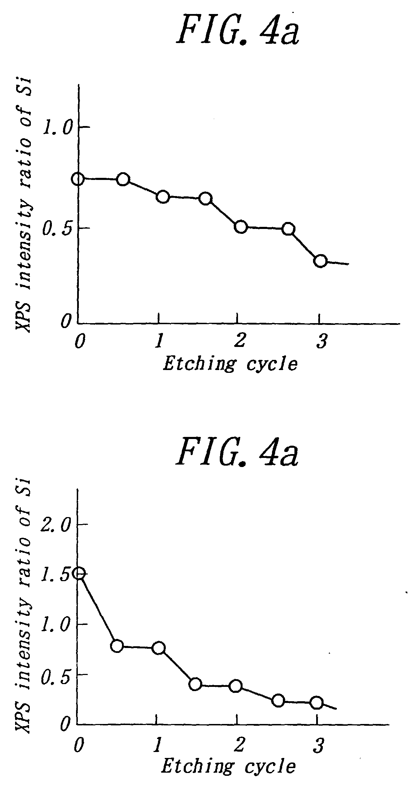

Figs. 4 show the XPS (X-ray photoelectron spectroscopy) intensity, from a surface of a silicon nitride film, of the silicon elements and the nitrogen elements constituting the silicon nitride film having a 12Å thickness when the silicon nitride film is dry-etched according to a method and equipment of the present invention. The nitrogen elements in the silicon nitride film are removed by contacting the film to a mixed gas plasma composed of hydrogen gas: argon gas=1:2 under a 0.4 Pa pressure for 45 minutes, and the silicon elements in the silicon nitride film are removed by contacting the film to a mixed gas plasma composed of hydrogen gas: argon gas=1:15 under a 0.3 Pa pressure for one minute.

Hereupon, in Figs. 4, the XPS intensities are represented as relative XPS intensities for silicon elements of a substrate as a standard. The wording "etching cycle" means a repeated number of the cycle in which the nitrogen element-removal and the silicon element-removal are carried out, respectively.

As is apparent from Figs.4, as the etching cycle is increased, the XPS intensities of the nitrogen elements and the silicon elements in the silicon nitride film are decreased step by step per 0.5 cycle. Thus, it is clear that the nitrogen elements and the silicon elements are removed independently. Moreover, from another experiment, it is estimated that the decreasing degree of the XPS intensity per one cycle corresponds to the about 1.9Å thickness of the silicon nitride film, and then, the thickness corresponds to about one molecular layer of the silicon nitride film. Thus, in dry-etching the solid material composed of the plural constituting elements by the method and the equipment of the present invention, the one molecular layer-dry etching can be realized.

As explained above, according to the present invention, even though various kinds of solid material are employed, the one molecular layer-dry etching can be performed for the solid material, and thereby the solid material can be dry-etched in an extremely controlled manner.

An embodiment of the present invention will now be described, by way of example only, with reference to the accompanying drawings, in which:
Fig.1 is a schematic view showing an embodiment of a known dry-etching equipment,
Figs.2A and 2B are typical views showing a dry-etching method in accordance with an embodiment of the present invention;
Fig.3 is a schematic view showing an embodiment of dry-etching equipment of the present invention, and
Figs.4A and 4B are XPS intensity-graphs showing decreasing degrees of silicon elements and nitrogen elements in a silicon nitride film when the film is dry-etched according to an embodiment of dry-etching method of the present invention.

The concrete dry-etching means in the method and the equipment of the present invention is not particularly restricted. However, as is mentioned in Figs. 2, it is preferable that gas molecules are plasma-excited to generate etching particles, later introduced perpendicularly to surfaces of a solid material and the thus generated etching induced substances are removed.

It enables the dry-etching to have a directionality, and thereby the solid material can be etched easily into a complex shape through the dry-etching. Moreover, high etching efficiency can be obtained.

In the above dry-etching, the incident energy of the etching particle to the surface of the solid material is preferably not more than 25eV. Thereby, the penetrating depth of the etching ion particle into the surface of the solid material can be controlled by an atomic layer-order or a molecular layer-order.

Moreover, the incident energy is preferably 10-20eV, more preferably 13-17eV. It enables the etching ion particle to penetrate into the surface of the solid material by about one atomic layer or one molecular layer. Then, by removing the thus generated etching induced substances, the one atomic layer-or the one molecular layer-dry etching can be realized in good controllability.

The different vapor treatment condition in the method of the present invention is controlled and set, depending on the kind of element constituting the solid material. For example, the gas molecular concentration may be different, depending on the element-kind. Moreover, the kind of gas molecule may be different. Besides, the percentage of the etching ion particles may be changed through the controlling of the degree of excitation of the gas molecules. Only one, two or more among from the above operations may be employed as the different vapor treatment condition.

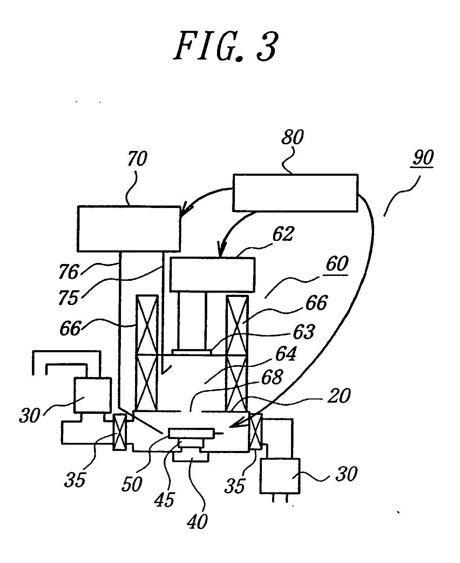

Fig. 3 is a schematic view showing a preferred embodiment in the dry-etching equipment according to the present invention.

A dry-etching equipment 90 shown in Fig. 3 has a vacuum chamber 20, a turbo molecular pump 30, a susceptor 40 to set a solid material 45, a shutter 50 provided so as to cover the solid material 45, an ECR plasma-generating equipment 60, a gas flow rate-controlling equipment 70 and a sequence controller 80. Then, the turbo molecular pump 30 is connected to a valve 35 and through the opening and shutting of the valve, the interior of the vacuum chamber 20 is evacuated.

The ECR plasma generating equipment 60 has a microwave-supplying equipment 62, an ECR plasma generating chamber 64 and an electromagnetic coil 66 around the ECR plasma generating chamber. The microwave generated in the microwave-supplying equipment 62 is supplied to the ECR plasma-generating chamber 64 through a quartz window 63 and generates an ECR plasma in the chamber. The ECR plasma is converged by the electromagnetic coil 66 and is introduced into the vacuum chamber 20 through a plasma inlet 68.

The gas flow rate-controlling equipment 70 can supply the gas to generate the ECR plasma, at its constant flow rate, into the ECR plasma-generating chamber 64 and the vacuum chamber 20 through gas supplying tubes 75 and 76.

The sequence controller 80 is connected to the shutter 50, the microwave-supplying equipment 62 and the gas flow rate controlling equipment 70, respectively, and can change successively the vapor treatment conditions for the dry-etching by controlling them so that they may work with one another.

For example, when the vapor treatment condition for the each kind of the constituting elements of the solid material is so determined that the gas molecular concentration may be different for the each kind, the gas molecular concentration may be controlled by adjusting the gas flow rate to be supplied to the ECR plasma-generating chamber 64 and the vacuum chamber 20 with the gas flow rate-controlling equipment 70.

Moreover, when the vapor treatment condition is also so determined that the kind of gas molecule may be different for the each kind of the constituting elements respectively, the kind of gas molecule to be used may be switched by the gas flow rate-controlling equipment 70.

Furthermore, when the percentage (amount) of the etching particles generated from the plasma excitation is changed, it can be done by changing the intensity of the microwave generated in the microwave-supplying equipment 62.

The shutter 50 is closed at the switching of the vapor treatment condition. Then, the shutter 50 is opened when the vapor treatment condition is set and the solid material is dry-etched. Thereby, the each kind of the constituting elements of the solid material can be removed independently, and thus, the solid material can be dry-etched.

As above-mentioned, since the shutter 50, the microwave-supplying equipment 62 and the gas flow rate-controlling equipment 70 are made to work with one another by the sequence controller 80, the each kind of the constituting elements can be removed successively.

### Examples:

This invention is further explained with the aid of the following examples, with reference to the drawings.

In this example, a silicon nitride film having a 12Å thickness was dry-etched by using such an equipment as shown in Fig. 3.

First of all, a hydrogen gas and an argon gas were introduced into the vacuum chamber 20 and the ECR plasma-generating chamber 64 so that the flow rate ratio may be the hydrogen gas: the argon gas=1 :2 and the pressure in the vacuum chamber and the plasma-generating chamber may be 0.4Pa. Then, a microwave having a 165W intensity generated in the microwave-supplying equipment 62 was introduced into the ECR plasma-generating chamber 64 via the quartz windows 63 and thereby an ECR plasma was generated in the chamber 64.

Next, the ECR plasma was introduced into the vacuum chamber 20 from the plasma inlet 68 and was irradiated to the silicon nitride film 45 by opening the shutter 50. At 45 minutes later, the shutter 50 was closed.

Then, a hydrogen gas and an argon gas were introduced into the vacuum chamber 20 and the ECR plasma-generating chamber 64 so that the flow rate ratio may be the hydrogen gas: the argon gas=1:15 and the pressure in the vacuum chamber and the plasma-generating chamber may be 0.3Pa, and an ECR plasma was generated as above-mentioned.

Next, the ECR plasma was introduced into the vacuum chamber 20 and was irradiated to the silicon nitride film 45 as above-mentioned. The irradiation time was one minute.

Thereafter, for determining the quantities of the silicon elements and the nitrogen elements in the silicon nitride film 45, their XPS intensities were investigated from the surface of the film.

Then, the above etching process as one cycle was carried out three times, and the silicon elements and the nitrogen elements in the three times-etched silicon nitride film were investigated by XPS as above-mentioned. The result was shown in Figs. 4. Hereupon, as above-mentioned, the XPS intensities in Figs. 4 are relative intensities for the silicon elements of the substrate as a standard.

The decreasing degrees of the XPS intensities per one cycle in Figs. 4 corresponds to one molecular layer of a silicon nitride material. Thus, according to the above mentioned method and equipment, the silicon nitride film turns out to be able to be dry-etched by one molecular layer.

Moreover, from that the XPS intensities of the silicon elements and the nitrogen elements is decreased step by step per 0.5 cycle respectively, it turns out that the silicon elements and the nitrogen elements are removed independently during the one cycle etching step.

Although the present invention was described in detail with reference to the above examples, this invention is not limited to the above disclosure and every kind of variation and modification may be made without departing from the scope of the present invention.

As is explained above, according to the dry-etching method and the dry-etching equipment of the present invention, a solid material having difficulty, being dry-etched can be treated by dry-etch. Moreover, various kinds of solid material can be dry-etched through the controlling of one atomic layer or one molecular layer by selecting an appropriate vapor treatment condition for each kind of the constituting elements of the solid material.

## Claims

1. A method for dry-etching a solid material composed of plural constituting elements comprising steps of:
setting the solid material on a support
vapor treating the solid material through the selection of a different vapor treatment condition for each of the constituting elements and thereby, removing each of the constituting elements independently.

2. A dry-etching method as defined in claim 1, wherein the step of vapor-treating further comprises the steps of:
plasma-exciting gas molecules in a vapor phase to generate etching particles, and
introducing the etching particles into the surfaces of the solid material and thereby removing the etching induced substances obtained from the reaction of the etching particles with the constituting elements of the solid material.

3. A dry-etching method as defined in claim 2, wherein the incident energy of the etching particle to the surface of the solid material is not more than 25eV.

4. A dry-etching method as defined in claim 3, wherein the incident energy of the etching particle to the surface of the solid material is 10-20eV.

5. A dry-etching method as defined in any one of claim 1 to 4, wherein the different vapor treatment conditions are so determined that the gas molecular concentration may be different for each of the constituting elements.

6. A dry-etching method as defined in any one of claims 1 to 5, wherein the different vapor treatment condition is so determined that the kind of gas molecule is different for each of the constituting elements.

7. A dry-etching method as defined in any one of claims 2 to 6, wherein the different vapor treatment condition is so determined that the percentage of the plasma-excited particles may be different for each of the constituting elements.

8. A dry-etching method as defined in any one of claims 2 to 7, wherein the solid material is composed of silicon nitride and the gas molecules are composed of hydrogen molecules.

9. An equipment for dry-etching a solid material composed of plural constituting elements, wherein the solid material is dry-etched through the independent removing of each of the constituting elements by selecting the vapor treatment condition for each of the constituting elements.

10. A dry-etching equipment as defined in claim 9, wherein the vapor treatment condition is a gas molecular concentration in a vapor phase.

11. A dry-etching equipment as defined in claim 9 or 10, wherein the vapor treatment condition is a kind of gas molecule.

12. A dry-etching equipment as defined in any one of claims 9 to 11, wherein the vapor treatment condition is a percentage of etching particles generated by plasma excitation.

13. A dry-etching equipment comprising a vacuum chamber, a vacuum pump, a susceptor to set a solid material, a shutter provided so as to cover the solid material, an ECR plasma-generating equipment, a gas flow rate-controlling equipment and a sequence controller, the sequence controller controlling a gas flow rate and generation of an ECR plasma to provide a different vapor treatment condition for each of the constituting elements of the solid material, and then, opening or closing the shutter so as to synchronize the provision of the different vapor treatment conditions, whereby the solid material is dry-etched through the independent removing of each of the constituting elements.
